# EUROPÄISCHE PATENTSCHRIFT

(11) **EP 3 258 602 B1**
(45) Veröffentlichungstag und Bekanntmachung des Hinweises auf die Patenterteilung: **04.09.2024**
(21) Anmeldenummer: 17176428.5
(22) Anmeldetag: 16.06.2017
(51) Int. Cl.: H03K 17/955, H03K 17/975

(54) **KAPAZITIVER SENSOR**
CAPACITIVE SENSOR
CAPTEUR CAPACITIF

(30) Priorität: 16.06.2016 DE 102016111033
(43) Veröffentlichungstag der Anmeldung: 20.12.2017
(73) Patentinhaber: SCHUNK SE & Co. KG Spanntechnik Greiftechnik Automatisierungstechnik, 74348 Lauffen am Neckar (DE)
(72) Erfinder: Becker, Ralf, 71672 Marbach (DE); Ohlheiser, Michael, 74927 Eschelbronn (DE)
(74) Vertreter: DREISS Patentanwälte PartG mbB

(56) Entgegenhaltungen:
- WO-A2-2011/130755
- FR-A1- 2 972 384
- US-A1- 2011 043 227
- US-A1- 2013 076 375

## Beschreibung

Die Erfindung betrifft einen kapazitiven Sensor, umfassend eine erste Sensorelektrode und eine zweite Sensorelektrode. Die Erfindung betrifft ferner eine dazugehörige Greif- bzw. Spannvorrichtung, eine dazugehörige Handhabungseinheit und ein dazugehöriges Verfahren.

Kapazitive Sensoren sind aus dem Stand der Technik in vielfältiger Art und Weise vorbekannt (vgl. Wikipedia-Eintrag). Kapazitive Sensoren arbeiten dabei auf Basis der Veränderung der Kapazität eines einzelnen Kondensators oder eines ganzen Kondensatorsystems. Kapazitive Sensoren basieren darauf, dass zwei Elektroden die "Platten" eines elektrischen Kondensators bilden, dessen Kapazität bzw. Kapazitätsänderung gemessen wird. Selbstverständlich muss die Geometrie der beiden Elektroden nicht plattenförmig sein, sondern kann auch eine beliebige andere Geometrie aufweisen. Kapazitive Sensoren aus dem Stand der Technik sind aus der WO 2011/130755 A2, der US 2011/043227 A1 und der US 2013/076375 A1 bekannt.

Eine Kapazitätsänderung kann sich dabei einerseits dadurch ergeben, dass der Abstand der Elektroden zueinander geändert wird. Die elektrische Kapazität bestimmt sich dabei nach der Formel C = Q/U. In einem Plattenkondensator konkretisiert sich die Formel hierbei zu C = ε*A/d. Eine Änderung des Plattenabstands d resultiert folglich in einer Kapazitätsänderung. Hierbei handelt es sich folglich um einen kapazitiven Drucksensor, bei dem eine Kraft auf eine der Platten ausgeübt wird, so dass sich der Plattenabstand verändert.

Andererseits ist auch denkbar, dass der Plattenabstand nicht verändert wird, sich jedoch die Kapazität dadurch ändert, dass ein elektrisch leitendes Material oder ein Dielektrikum in die unmittelbare Umgebung einer der Sensorelektroden gebracht wird. Diese sog. Abstands- bzw. Näherungssensoren basieren darauf, dass sich das annähernde Objekt mit einer der beiden Sensorelektroden einen weiteren elektrischen Kondensator ausbildet, wobei sich die Gesamtkapazität des Systems ändert, indem gilt totale Kapazität = Kapazität des Kondensators zwischen den beiden Sensorelektroden + Kapazität des neu ausgebildeten Kondensators.

Bei der Verwendung von kapazitiven Sensoren als Kraft- bzw. Drucksensoren muss regelmäßig eine Schirmelektrode eingesetzt werden, um lediglich die Prozesskraft, nämlich die Kraft auf eine der Sensorelektroden zu detektieren und äußere Einflüsse, insbesondere externe elektrische Felder, zu messenden Kraft durch äußere Störungen. Hierzu kann entweder eine der Sensorelektroden geerdet sein, oder es wird regelmäßig eine zusätzliche Schirmelektrode eingesetzt.

Bei Anwendungen, beispielsweise in der Handhabungstechnik, insbesondere beim Einsatz von Greif- bzw. Spannvorrichtungen an Handhabungseinrichtungen, werden regelmäßig sowohl Drucksensoren als auch Näherungssensoren zum sicheren Betreiben eines derartigen Systems benötigt. Insbesondere bei der Mensch-Roboter-Kollaboration werden höchste Anforderungen an die Arbeitssicherheit gestellt, um Kollisionen zwischen Mensch und Roboter bzw. Mensch und Endeffektor des Roboters wirksam zu verhindern. Für gewisse Anwendungen werden hierbei Kraftsensoren zur Messung der auf beispielsweise eine Greif- bzw. Spannvorrichtung einwirkenden Druckkraft benötigt. Für andere Anwendungen werden hingegen Näherungssensoren benötigt, beispielsweise um eine Kollision mit einer Bedienperson vollständig zu verhindern. Insofern werden zwei unterschiedliche kapazitive Sensoren, nämlich ein Kraft bzw. Drucksensor und ein Näherungssensor benötigt und beispielsweise an einer Greif- bzw. Spannvorrichtung und/oder an einer Handhabungseinrichtung, wie beispielsweise einem 6-Achs-Roboter, vorgesehen. Das Vorsehen von zwei Sensoren benötigt zum einen Bauteile, Bauraum und verursacht nicht unerhebliche Kosten.

Der Erfindung liegt daher die Aufgabe zugrunde, diesen Nachteilen des Standes der Technik Abhilfe zu schaffen.

Diese Aufgabe wird durch einen kapazitiven Sensor mit den Merkmalen des Anspruchs 1 gelöst.

Es ist demnach vorgesehen, dass der Sensor eine erste Schaltstellung aufweist, in der die erste Sensorelektrode und die zweite Sensorelektrode einen Kondensator bilden. Hierbei ist die erste Sensorelektrode als Schirmelektrode ausgebildet. Dabei kann eine Kapazitätsänderung des Kondensators durch eine auf die erste Sensorelektrode ausübbare Kraft mittels eines die erste Sensorelektrode berührenden Objekts detektiert werden. Wird eine Kraft durch das Objekt auf die erste Sensorelektrode ausgeübt, insbesondere indem das Objekt, beispielsweise ein Körperteil einer Bedienperson auf die erste Sensorelektrode drückt, so ändert sich der Abstand der Sensorelektroden zueinander, was auf Grund der Kondensatorformel in einer Kapazitätänderung resultiert. Es kann folglich eine Berührung und die Kraft der Berührung detektiert werden.

Ferner ist erfindungsgemäß vorgesehen, dass der Sensor eine zweite Schaltstellung aufweist, in der an der ersten Sensorelektrode ein elektrisches Feld derart erzeugbar ist, dass durch Annäherung eines Objekts an die erste Sensorelektrode eine Kapazitätsänderung detektierbar ist. In dieser zweiten Schaltstellung ist selbstverständlich immer noch ein erster Kondensator zwischen der ersten Sensorelektrode und der zweiten Sensorelektrode vorhanden. Allerdings wirkt die erste Sensorelektrode nun nicht mehr als Schirmelektrode, stattdessen ist eine Spannung derart anlegbar, dass elektrische Feldlinien aus der ersten Sensorelektrode austreten. Diese Feldlinien haben das Bestreben, in die zweite Sensorelektrode zu münden. Allerdings streuen Feldlinien aus der ersten Sensorelektrode aus, die geometrisch bedingt keinen direkten Weg zur zweiten Sensorelektrode haben. Nähert sich nun ein Objekt ohne physikalischen Kontakt mit der ersten Sensorelektrode an die erste Sensorelektrode, so bündeln sich die streuenden Feldlinien bzw. ein Teil der streuenden Feldlinien in dem sich nähernden Objekt, was zu einer detektierbaren Kapazitätsänderung führt, indem zwischen dem sich nähernden Objekt und der ersten Sensorelektrode ein zusätzlicher Kondensator ausgebildet wird. Die gemessene Gesamtkapazität vergrößert sich folglich, indem gilt, totale Kapazität = Kapazität des ersten Kondensators zwischen den Sensorleketroden + Kapazität des zweiten Kondensators zwischen erste Sensorelektrode und sich näherndem Objekt.

Insgesamt ergibt sich erfindungsgemäß folglich ein kapazitiver Sensor, der sowohl als Druck- bzw. Kraftsensor als auch als Näherungssensor einsetzbar ist, so dass zum einen eine taktile Sensorik in der ersten Schaltstellung vorhanden ist, in der Prozesskräfte erfassbar sind, die auf das Element wirken, an dem der kapazitive Sensor angeordnet ist. In der zweiten Schaltstellung kann hingegen eine kapazitive Aura um das Element, an dem der kapazitive Sensor angeordnet ist, gemessen werden, indem ein sich näherndes Objekt an das Element ohne physikalischen Kontakt zwischen dem sich nähernden Objekt und dem Sensor detektiert wird.

Vorzugsweise ist die erste Sensorelektrode in der ersten Schaltstellung geerdet. Hierdurch ergibt sich eine besonders vorteilhaft wirkende Schutzelektrode, die den Kondensator zwischen erster und zweiter Sensorelektrode vor äußeren Einflüssen schützt.

Zusätzlich oder alternativ kann in der zweiten Schaltstellung die zweite Sensorelektrode geerdet sein.

Eine weitere vorteilhafte Ausgestaltung der Erfindung sieht vor, dass eine Steuereinrichtung vorgesehen ist, die zum Messen einer Kapazitätsänderung und/oder zum Anlegen einer Spannung an die Sensorelektroden und/oder zum Wechseln der Schaltstellungen ausgebildet ist.

Vorteilhafterweise ist die Steuereinrichtung elektrisch mit der ersten Sensorelektrode und der zweiten Sensorelektrode verbunden, so dass die Steuereinrichtung eine Spannung bzw. eine Potentialdifferenz zwischen den Sensorelektroden erzeugen kann. Günstigerweise ist die Steuereinrichtung zudem zur Messung der Kapazitätsänderung ausgebildet. Hierzu kann beispielsweise ein RC-Glied oder eine andere bekannte Messmethode zur Messung einer Kapazitätsänderung Verwendung finden. Schließlich ist vorteilhafterweise die Steuereinrichtung zudem zum Wechseln der Schaltstellungen ausgebildet.

Vorteilhaft ist auch, wenn die Steuereinrichtung zur Veranlassung einer Aktion basierend auf einer gemessenen Kapazitätsänderung ausgebildet ist. Die Aktion kann beispielsweise darin bestehen, eine Bewegung des Elements, an dem der kapazitive Sensor angeordnet ist, zu unterbrechen. Beispielsweise kann der kapazitive Sensor an einer Greif- bzw. Spannvorrichtung und/oder an einer Handhabungseinrichtung, wie beispielsweise einem Roboter, an dem die Greif- bzw. Spannvorrichtung angeordnet ist, vorgesehen sein. Wirkt in der ersten Schaltstellung eine Kraft auf die erste Sensorelektrode, so dass eine Kapazitätsänderung gemessen wird, so kann folglich die Bewegung der Greif- bzw. Spannvorrichtung im Raum gestoppt werden bzw. eine Bewegungsrichtungsinvertierung durchgeführt werden. In der zweiten Schaltstellung kann ebenfalls eine Bewegungsunterbrechung oder zumindest ein Verlangsamen der Bewegung in Richtung eines sich nähernden Objekts veranlasst werden, so dass eine Kollision der Greif- bzw. Spannvorrichtung mit dem sich nähernden Objekt verhindert werden kann bzw. die Krafteinwirkung im Kollisionsfall reduziert werden kann.

Die erste Sensorelektrode ist als Gehäuse mit einem Gehäuseboden und einem Gehäusemantel ausgebildet, wobei die zweite Sensorelektrode innerhalb des Gehäuses angeordnet ist. Somit kann der Kondensator in der ersten Schaltstellung in besonders günstiger Weise vor äußeren Einflüssen geschützt werden. Das Gehäuse kann dabei beispielsweise topfförmig oder auch kastenförmig ausgebildet sein.

Besonders bevorzugt ist, wenn eine Kraft auf die erste Sensorelektrode in der ersten Schaltstellung ein Durchbiegen des Gehäusebodens und damit eine Abstandsänderung der Sensorelektroden bewirkt, was eine Kapazitätsänderung induziert. Hierzu kann die erste Sensorelektrode biegbar ausgebildet sein.

Die zweite Sensorelektrode ist auf einem nicht-leitenden Element, insbesondere einer Leiterplatte oder einer Glasplatte, angeordnet.

Eine besonders bevorzugte Weiterbildung der Erfindung ergibt sich daraus, dass die zweite Sensorelektrode plattenförmig ausgebildet ist.

In diesem Zusammenhang ist vorgesehen, dass der Gehäusemantel eine Stufe aufweist, an der das nicht-leitende Element angeordnet ist. Insofern kann ein besonders einfach aufgebauter Kondensator bereitgestellt werden, indem das nicht leitende Element unmittelbar an der Stufe der ersten Sensorelektrode anliegt und somit ein Kondensator bereitgestellt wird, in dem das nicht leitende Element als Dielektrikum zwischen den beiden Sensorelektroden wirkt. Durch das Vorsehen an der Stufe wird zudem eine Beabstandung der Sensorelektroden zueinander bereitgestellt.

Zwischen den beiden Sensorelektroden selbst kann insbesondere ein Hohlraum vorhanden sein. Dieser kann entweder durch ein elastisch nachgiebiges Dielektrikum ausgefüllt sein oder aber es kann Luft als Dielektrikum im Hohlraum vorhanden sein.

Besonders bevorzugt ist, wenn ein Wechselschalter zum Wechseln der Schaltstellungen vorgesehen ist, wobei der Wechselschalter kabelgebunden oder kabellos steuerbar ist. Die Ansteuerung des Wechselschalters kann hierbei insbesondere durch die Steuereinrichtung erfolgen.

Vorzugsweise ist dabei die erste Sensorelektrode metallisch. Eine metallische Sensorelektrode erlaubt insbesondere auch ein elastisches Durchbiegen der Sensorelektrode. Zusätzlich oder alternativ kann die zweite Sensorelektrode aus Kupfer oder Indiumzinnoxid (ITO) bestehen oder ein solches Material umfassen.

Besonders bevorzugt ist, wenn die Dielektrizitätszahl eines sich in der zweiten Schaltstellung annähernden Objekts 1 bis 10, insbesondere 2 bis 8, beträgt. Hierdurch ergibt sich eine signifikante und messbare Änderung der Gesamtkapazität des Kondensatorsystems. Insbesondere weist der zweite Kondensator zwischen Objekt und erster Sensorelektrode folglich eine signifikante Kapazität auf.

Eine vorteilhafte Weiterbildung der Erfindung sieht vor, dass ein RC-Glied zum Messen der Kapazitätsänderung vorgesehen ist. Eine Messung mittels eines RC-Glieds ist auf besonders einfache Art und Weise möglich.

Die eingangs gestellte Aufgabe wird auch durch eine Greif- oder Spannvorrichtung mit einem daran angeordneten, erfindungsgemäßen Sensor gelöst. Damit können zum einen in der ersten Schaltstellung auf die Greif- oder Spannvorrichtung wirkende Prozesskräfte gemessen werden. Zum anderen kann eine Kollision eines Objekts, insbesondere eines Körperteils einer Bedienperson, mit der Greif- oder Spannvorrichtung in der zweiten Schaltstellung wirksam verhindert werden.

Ferner wird die eingangs gestellte Aufgabe auch gelöst durch eine Handhabungseinrichtung, insbesondere einen Roboter, mit einem Trägerarm und mit einer am Trägerarm angeordneten oder anordenbaren Greif- oder Spannvorrichtung, wobei ein Sensor nach einem der vorhergehenden Ansprüche am Trägerarm und/oder an der Greif- oder Spannvorrichtung vorgesehen ist. Auch hier können in der ersten Schaltstellung Prozesskräfte gemessen werden. In der zweiten Schaltstellung kann eine Kollision der Handhabungseinrichtung bzw. des als Greif- oder Spannvorrichtung ausgebildeten Endeffektors wirksam verhindert werden, indem beispielsweise bei gemessener Kapazitätsänderung durch Annäherung einer Person an die Handhabungseinrichtung, die Bewegung der Handhabungseinrichtung auf die Person verlangsamt oder angehalten wird oder sogar eine Bewegungsrichtungsinvertierung durchgeführt wird.

Schließlich wird die eingangs genannte Aufgabe auch gelöst durch ein Verfahren zum Betreiben eines erfindungsgemäßen Sensors, wobei eine Steuereinrichtung zur Veranlassung einer Aktion basierend auf einer vom Sensor gemessenen Kapazitätsänderung vorgesehen ist, umfassend die folgenden Schritte:
a. Messen der Kapazität mittels der Steuereinrichtung in der ersten Schaltstellung und/oder der zweiten Schaltstellung;
b. Veranlassen einer Aktion, wenn die in der ersten Schaltstellung und/oder der zweiten Schaltstellung gemessene Kapazitätsänderung einen Grenzwert überschreitet.

Ist der Sensor beispielsweise an einem Endeffektor einer Handhabungseinrichtung, insbesondere einem Roboter, angeordnet, so kann die Aktion insbesondere darin bestehen, die Bewegung des Endeffektors im Raum zu verlangsamen, zu unterbrechen oder die Bewegungsrichtung zu invertieren.

Weitere Einzelheiten und vorteilhafte Ausgestaltungen der Erfindung sind der folgenden Beschreibung zu entnehmen, anhand derer die in den Figuren dargestellte Ausführungsform der Erfindung näher beschrieben und erläutert ist. Es zeigen:
- Figur 1: eine schematische Darstellung eines kapazitiven Sensors in einer ersten Schaltstellung;
- Figur 2: eine schematische Darstellung des kapazitiven Sensors gemäß Figur 1 in einer zweiten Schaltstellung; und
- Figur 3: Darstellung gemäß Figur 2, wobei sich ein Objekt an die erste Sensorelektrode annähert.

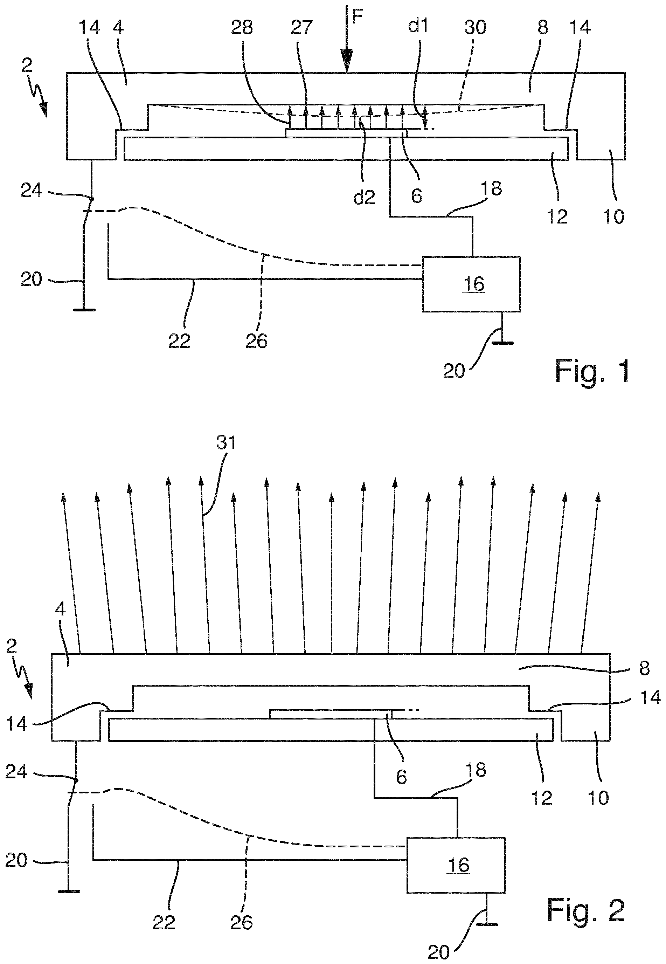

Die Figuren 1 bis 3 zeigen einen insgesamt mit dem Bezugszeichen 2 bezeichneten kapazitiven Sensor. Der kapazitive Sensor umfasst dabei eine erste Sensorelektrode 4 und eine zweite dazu beabstandet und gegenüberliegend angeordnete Sensorelektrode 6. Die erste Sensorelektrode 4 ist dabei gehäuseförmig mit einem plattenförmigen Gehäuseboden 8 und einer davon abragenden Gehäuseseite, die einen Gehäusemantel 10 darstellt, ausgebildet.

Die zweite Sensorelektrode 6 ist ebenfalls plattenförmig und aus Kupfer bestehend ausgebildet und an einer Leiterplatte (Platine) 12 angeordnet. Der Gehäusemantel 10 der ersten Sensorelektrode 4 weist eine Stufe bzw. Schulter 14 auf. An dieser Stufe ist die Leiterplatte 12 unmittelbar angeordnet.

Der kapazitive Sensor 2 weist ferner eine als Microcontroller ausgebildete Steuereinrichtung 16 auf. Die Steuereinrichtung 16 ist dabei zum einen über einen elektrischen Leiter 18 mit der zweiten Sensorelektrode 6 verbunden. Zum anderen weist diese einen Erdungsanschluss 20 auf. Ferner ist ein elektrischer Leiter 22 vorgesehen, der die Steuereinrichtung 16 mit einem Wechselschalter 24 verbindet. Der Wechselschalter 24 ist dabei, wie mit der gestrichelten Linie 26 angedeutet, kabelgebunden oder kabellos zwischen zwei Schaltstellungen steuerbar.

Die Funktionsweise des kapazitiven Sensors 2 ist sodann wie folgt:
In der in Figur 1 gezeigten ersten Schaltstellung ist der Wechselschalter 24 so geschaltet, dass die erste Sensorelektrode 4 über den Erdungsanschluss 20 geerdet ist. Mittels der Steuereinrichtung 16 wird sodann eine Spannung zwischen den Sensorelektroden 4, 6 erzeugt, wobei Feldlinien, wie mit den Pfeilen 27 angedeutet, von der zweiten Sensorelektrode 6 zur ersten Sensorelektrode 4 verlaufen. Die beiden Sensorelektroden 4, 6 bilden folglich einen Plattenkondensator aus. Die Sensorelektroden sind nämlich von einem Hohlraum 28 voneinander getrennt, wobei die Luft im Hohlraum als Dielektrikum wirkt. In dieser Schaltstellung ist die geerdete, erste Sensorelektrode 4 zugleich Schirmelektrode, wobei die zweite Sensorelektrode 6 vollständig innerhalb des von der ersten Sensorelektrode 4 umschlossenen Volumens angeordnet ist. Störende äußere elektrische Felder werden folglich im Wesentlichen vollständig abgeschirmt und können nicht in das von der ersten Sensorelektrode 4 umschlossene Volumen gelangen.

Wirkt sodann eine Kraft F auf den Gehäuseboden 8 der ersten Sensorelektrode 4, so wird, wie in Figur 1 mit der gestrichelten Linie 30 angedeutet, der Gehäuseboden durchgebogen. Hierbei ändert sich die Distanz zwischen Gehäuseboden 8 und der zweiten Sensorelektrode 6 und damit die Distanz zwischen den beiden Sensorelektroden 4, 6 von einer ursprünglichen Distanz d1 zu einer minimalen Distanz d2 am Scheitelpunkt der durchgebogenen Sensorelektrode 4. Dies löst eine Kapazitätsänderung des Kondensators aus (Kondensatorformel C = ε*A/D). Diese Kapazitätsänderung wird von der Steuereinrichtung 16, beispielsweise mittels eines RC-Glieds, detektiert. Somit ist der kapazitive Sensor 2 in der ersten Schaltstellung als Kraftsensor ausgebildet, der eine Kraft auf den Sensor misst und detektiert.

In der zweiten Schaltstellung ist der Wechselschalter 24 von der Steuereinrichtung 16 in die zweite Schaltposition geschaltet, in der die Sensorelektrode 4 mit der Steuereinrichtung 16 über den elektrischen Leiter 22 verbunden ist. Die zweite Sensorelektrode 6 ist mittels des Erdungsanschlusses 20 geerdet. Durch die Steuereinrichtung 16 wird sodann eine Spannung zwischen den Sensorelektroden 4, 6 erzeugt. Somit gehen elektrische Feldlinien von der ersten Sensorelektrode 4 aus, die nun nicht mehr als Schirmelektrode wirkt.

Diese Feldlinien streben zur zweiten Sensorelektrode 6 hin. Allerdings haben einige Feldlinien geometrisch bedingt keinen direkten Weg zur zweiten Sensorelektrode 6 und streuen somit aus der äußeren Sensoroberfläche der zweiten Sensorelektrode 4 aus, was in Figur 2 mit den Pfeilen 31 schematisch angedeutet ist.

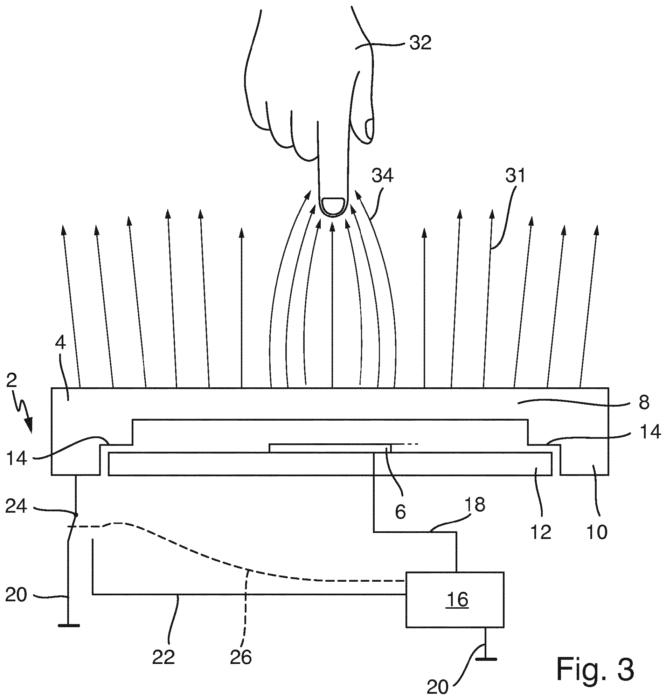

Nähert sich sodann ein Objekt, wie beispielsweise der Finger 32 eines Menschen, wie in Figur 3 gezeigt, so bündeln sich die streuenden Feldlinien oder zumindest ein Teil der Feldlinien, was mit den Pfeilen 34 angedeutet ist, an dem sich nähernden Objekt.

Hierbei wird ein zweiter Kondensator zwischen der ersten Sensorelektrode 4 und dem sich nähernden Objekt 32 ausgebildet. Insofern wird zusätzlich zur ersten Kapazität zwischen ersten Sensorelektrode 4 und zweiter Sensorelektrode 6 eine zweite Kapazität zwischen erster Sensorelektrode 4 und Objekt 32 ausgebildet. Diese Kapazitätänderung wird von der Steuereinrichtung 16 detektiert.

Insgesamt wird mit vorliegender Erfindung ein kapazitiver Sensor 2 bereitgestellt, der in einer ersten Schaltstellung als Kraftsensor ausgebildet ist, während dieser in der zweiten Schaltstellung als Näherungssensor ausgebildet ist.

Um folglich sowohl eine taktile Sensorik zur Erfassung von Prozesskräften, als auch eine kapazitive Aura zur Detektion der Annäherung eines insbesondere menschlichen Objekts bereitzustellen, wird lediglich ein kapazitiver Sensor 2 benötigt.

Der kapazitive Sensor 2 kann insbesondere an Greif- oder Spannvorrichtungen, die an einem Roboter angeordnet sind, eingesetzt werden. Insbesondere bei der Mensch-Roboter-Kollaboration müssen nämlich bei einigen Prozessschritten auf die Greif- oder Spannvorrichtung wirkende Prozesskräfte in der ersten Schaltstellung ermittelt werden. In anderen Prozessschritten muss hingegen eine Annäherung einer Person an die Greif- oder Spannvorrichtung zur Kollisionsverhinderung detektiert werden. Es kann folglich ein sicheres Betreiben eines Roboters mit Endeffektor in menschlicher Umgebung bereitgestellt werden.

## Patentansprüche

1. Kapazitiver Sensor (2), umfassend eine erste Sensorelektrode (4) und eine zweite Sensorelektrode (6), wobei der Sensor (2) eine erste Schaltstellung aufweist, in der die erste Sensorelektrode (4) und die zweite Sensorelektrode (6) einen Kondensator bilden, wobei die erste Sensorelektrode (4) als Schirmelektrode ausgebildet ist, und wobei eine Kapazitätsänderung des Kondensators durch eine auf die erste Sensorelektrode (4) ausübbare Kraft F mittels eines die erste Sensorelektrode (4) berührenden Objekts detektierbar ist, und dass der Sensor (2) eine zweite Schaltstellung aufweist, in der an der ersten Sensorelektrode (4) ein elektrisches Feld derart erzeugbar ist, dass durch Annäherung eines Objekts (32) an die erste Sensorelektrode (4) eine Kapazitätsänderung detektierbar ist, wobei die erste Sensorelektrode (4) als Gehäuse mit einem plattenförmigen Gehäuseboden (8) und einer davon abragenden Gehäuseseite, die einen Gehäusemantel (10) darstellt, ausgebildet ist, wobei die zweite Sensorelektrode (6) innerhalb des Gehäuses angeordnet ist, wobei die zweite Sensorelektrode (6) auf einem nicht-leitenden Element (12), insbesondere einer Leiterplatte oder einer Glasplatte, angeordnet ist, und wobei der Gehäusemantel (10) eine Schulter (14) aufweist, an der das nicht-leitende Element (12) angeordnet ist.

2. Kapazitiver Sensor (2) nach Anspruch 1, **dadurch gekennzeichnet, dass** in der ersten Schaltstellung die erste Sensorelektrode (4) geerdet ist, und/oder dass in der zweiten Schaltstellung die zweite Sensorelektrode (6) geerdet ist.

3. Kapazitiver Sensor (2) nach Anspruch 1 oder 2, **dadurch gekennzeichnet, dass** eine Steuereinrichtung (16) vorgesehen ist, die zum Messen einer Kapazitätsänderung und/oder zum Anlegen einer Spannung an die Sensorelektroden (4, 6) und/oder zum Wechseln der Schaltstellungen ausgebildet ist.

4. Kapazitiver Sensor (2) nach Anspruch 3, **dadurch gekennzeichnet, dass** die Steuereinrichtung (16) zur Veranlassung einer Aktion basierend auf einer gemessenen Kapazitätsänderung ausgebildet ist.

5. Kapazitiver Sensor (2) nach Anspruch 4, **dadurch gekennzeichnet, dass** eine Kraft auf die erste Sensorelektrode (4) in der ersten Schaltstellung ein Durchbiegen des Gehäusebodens (8) und damit eine Abstandsänderung der Sensorelektroden (4, 6) bewirkt.

6. Kapazitiver Sensor (2) nach einem der vorhergehenden Ansprüche, **dadurch gekennzeichnet, dass** die zweite Sensorelektrode (6) plattenförmig ausgebildet ist.

7. Kapazitiver Sensor (2) nach einem der vorhergehenden Ansprüche, **dadurch gekennzeichnet, dass** ein Wechselschalter (24) zum Wechseln der Schaltstellungen vorgesehen ist, wobei der Wechselschalter (24) kabelgebunden oder kabellos steuerbar ist.

8. Kapazitiver Sensor (2) nach einem der vorhergehenden Ansprüche, **dadurch gekennzeichnet, dass** die Sensorelektroden (4, 6) durch einen Hohlraum (28) voneinander beabstandet sind.

9. Kapazitiver Sensor (2) nach einem der vorhergehenden Ansprüche, **dadurch gekennzeichnet, dass** die erste Sensorelektrode (4) metallisch ist und/oder dass die zweite Sensorelektrode (6) aus Kupfer oder Indiumzinnoxid besteht oder ein solches Material umfasst.

10. Kapazitiver Sensor (2) nach einem der vorhergehenden Ansprüche, **dadurch gekennzeichnet, dass** ein RC-Glied zum Messen der Kapazitätsänderung vorgesehen ist.

11. Greif- oder Spannvorrichtung mit einem daran angeordneten kapazitiven Sensor (2) nach einem der vorhergehenden Ansprüche.

12. Handhabungseinrichtung, insbesondere Roboter, mit einem Trägerarm und mit einer am Trägerarm angeordneten oder anordenbaren Greif- oder Spannvorrichtung, wobei ein kapazitiver Sensor (2) nach einem der vorhergehenden Ansprüche am Trägerarm und/oder an der Greif- oder Spannvorrichtung vorgesehen ist.

13. Verfahren zum Betreiben eines kapazitiven Sensors (2) nach Anspruch 4, umfassend die folgenden Schritte:
a. Messen der Kapazität mittels der Steuereinrichtung (16) in der der ersten Schaltstellung und/oder der zweiten Schaltstellung;
b. Veranlassen einer Aktion, wenn die in der ersten Schaltstellung und/oder der zweiten Schaltstellung gemessene Kapazitätsänderung einen Grenzwert überschreitet.

## Claims

1. Capacitive sensor (2), comprising a first sensor electrode (4) and a second sensor electrode (6), wherein the sensor (2) has a first switching position in which the first sensor electrode (4) and the second sensor electrode (6) form a capacitor, wherein the first sensor electrode (4) is designed as a shield electrode, and wherein a capacitance change of the capacitor is detectable by a force F that can be exerted on the first sensor electrode (4) by means of an object in contact with the first sensor electrode (4), and in that the sensor (2) has a second switching position in which an electrical field can be generated at the first sensor electrode (4) such that, when an object (32) approaches the first sensor electrode (4), a capacitance change can be detected, wherein the first sensor electrode (4) is designed as a housing having a planar housing base (8) and a housing side which projects therefrom and depicts a housing casing (10), wherein the second sensor electrode (6) is arranged within the housing, wherein the second sensor electrode (6) is arranged on a non-conductive element (12), in particular a circuit board or a glass plate, and wherein the housing casing (10) has a shoulder (14) on which the non-conductive element (12) is arranged.

2. Capacitive sensor (2) according to claim 1, **characterized in that** in the first switching position, the first sensor electrode (4) is earthed, and/or **in that** in the second switching position, the second sensor electrode (6) is earthed.

3. Capacitive sensor (2) according to claim 1 or 2, **characterized in that** a control device (16) is provided, which is designed to measure a capacitance change and/or to apply a voltage to the sensor electrodes (4, 6) and/or to change the switching positions.

4. Capacitive sensor (2) according to claim 3, **characterized in that** the control device (16) is designed to initiate an action based on a measured capacitance change.

5. Capacitive sensor (2) according to claim 4, **characterized in that** a force on the first sensor electrode (4) in the first switching position causes the housing base (8) to bend and thus causes a change in distance between the sensor electrodes (4, 6).

6. Capacitive sensor (2) according to any of the preceding claims, **characterized in that** the second electrode (6) is planar.

7. Capacitive sensor (2) according to any of the preceding claims, **characterized in that** a changeover switch (24) for changing the switching positions is provided, it being possible for the changeover switch (24) to be controlled in a wired or wireless manner.

8. Capacitive sensor (2) according to any of the preceding claims, **characterized in that** the sensor electrodes (4, 6) are spaced apart from one another by a cavity (28).

9. Capacitive sensor (2) according to any of the preceding claims, **characterized in that** the first sensor electrode (4) is metal and/or **in that** the second sensor electrode (6) consists of copper or indium tin oxide or comprises such a material.

10. Capacitive sensor (2) according to any of the preceding claims, **characterized in that** an RC element is provided for measuring the capacitance change.

11. Gripping or clamping device having a capacitive sensor (2) arranged thereon according to any of the preceding claims.

12. Handling device, in particular a robot, comprising a support arm and a gripping or clamping device arranged or arrangeable on the support arm, wherein a capacitive sensor (2) according to any of the preceding claims is provided on the support arm and/or on the gripping or clamping device.

13. Method for operating a capacitive sensor (2) according to claim 4, comprising the following steps:
a. measuring the capacitance by means of the control device (16) in the first switching position and/or the second switching position;
b. causing an action if the capacitance change measured in the first switching position and/or the second switching position exceeds a limit value.

## Revendications

1. Capteur capacitif (2), comprenant une première électrode de capteur (4) et une seconde électrode de capteur (6), dans lequel le capteur (2) présente une première position de commutation, dans laquelle la première électrode de capteur (4) et la seconde électrode de capteur (6) forment un condensateur, dans lequel la première électrode de capteur (4) est conçue comme une électrode écran et dans lequel une modification de capacité du condensateur peut être détectée par une force F pouvant être exercée sur la première électrode de capteur (4) à l'aide d'un objet touchant la première électrode de capteur (4) et que le capteur (2) présente une seconde position de commutation, dans laquelle un champ électrique peut être produit sur la première électrode de capteur (4) de sorte qu'une modification de capacité peut être détectée par l'approche d'un objet (32) vers la première électrode de capteur (4), dans lequel la première électrode de capteur (4) est conçue comme un boîtier avec un fond de boîtier (8) en forme de plaque et un côté de boîtier dépassant de celui-ci, qui représente une enveloppe de boîtier (10), dans lequel la seconde électrode de capteur (6) est disposée à l'intérieur du boîtier, dans lequel la seconde électrode de capteur (6) est disposée sur un élément non conducteur (12), en particulier une carte de circuit ou une plaque de verre et dans lequel l'enveloppe de boîtier (10) présente un épaulement (14), sur lequel l'élément non conducteur (12) est disposé.

2. Capteur capacitif (2) selon la revendication 1, **caractérisé en ce que** dans la première position de commutation la première électrode de capteur (4) est mise à la terre et/ou **que** dans la seconde position de commutation la seconde électrode de capteur (6) est mise à la terre.

3. Capteur capacitif (2) selon la revendication 1 ou 2, **caractérisé en ce qu'**un appareil de commande (16) est prévu, qui est conçu pour la mesure d'une modification de capacité et/ou pour l'application d'une tension aux électrodes de capteur (4, 6) et/ou pour le changement des positions de commutation.

4. Capteur capacitif (2) selon la revendication 3, **caractérisé en ce que** l'appareil de commande (16) est conçu pour le lancement d'une action sur la base d'une modification de capacité mesurée.

5. Capteur capacitif (2) selon la revendication 4, **caractérisé en ce qu'**une force sur la première électrode de capteur (4) dans la première position de commutation entraîne une flexion du fond de boîtier (8) et ainsi une modification d'écartement entre les électrodes de capteur (4, 6).

6. Capteur capacitif (2) selon l'une des revendications précédentes, **caractérisé en ce que** la seconde électrode de capteur (6) est conçue en forme de plaque.

7. Capteur capacitif (2) selon l'une des revendications précédentes, **caractérisé en ce qu'**un commutateur (24) est prévu pour le changement des positions de commutation, dans lequel le commutateur (24) peut être commandé par câble ou sans câble.

8. Capteur capacitif (2) selon l'une des revendications précédentes, **caractérisé en ce que** les électrodes de capteur (4, 6) sont espacées l'une de l'autre par une cavité (28).

9. Capteur capacitif (2) selon l'une des revendications précédentes, **caractérisé en ce que** la première électrode de capteur (4) est métallique et/ou **que** la seconde électrode de capteur (6) est constituée de cuivre ou d'oxyde d'indium et d'étain ou comprend un tel matériau.

10. Capteur capacitif (2) selon l'une des revendications précédentes, **caractérisé en ce qu'**un organe RC est prévu pour la mesure de la modification de capacité.

11. Dispositif de préhension ou de serrage comportant un capteur capacitif (2) selon l'une des revendications précédentes disposé sur celui-ci.

12. Dispositif de manipulation, en particulier robot, comportant un bras de support et comportant un dispositif de préhension ou de serrage disposé ou pouvant être disposé sur le bras de support, dans lequel un capteur capacitif (2) selon l'une des revendications précédentes est prévu sur le bras de support et/ou sur le dispositif de préhension ou de serrage.

13. Procédé pour l'exploitation d'un capteur capacitif (2) selon la revendication 4, comprenant les étapes suivantes :
a. mesure de la capacité à l'aide de l'appareil de commande (16) dans la première position de commutation et/ou la seconde position de commutation ;
b. lancement d'une action, lorsque la modification de capacité mesurée dans la première position de commutation et/ou la seconde position de commutation dépasse une valeur limite.
